# FASCICULE DE BREVET EUROPEEN

(11) **EP 0 429 037 B1**
(45) Date de publication et mention de la délivrance du brevet: **23.03.1994**
(21) Numéro de dépôt: 90122070.7
(22) Date de dépôt: 19.11.1990
(51) Int. Cl.: H05K 9/00

(54) **Blindage pour circuit radiofréquence**
Abschirmung für Radiofrequenzschaltung
Shield for radio-frequency circuit

(30) Priorité: 20.11.1989 FR 8915188
(43) Date de publication de la demande: 29.05.1991
(73) Titulaire: ALCATEL RADIOTELEPHONE, 75008 Paris (FR)
(72) Inventeur: Trinh Van, Christian, F-91800 Brunoy (FR)
(74) Mandataire: Weinmiller, Jürgen

(56) Documents cités:
- DE-A- 2 656 489
- DE-A- 3 520 531
- FR-A- 1 577 883
- FR-A- 2 629 664
- GB-A- 2 200 253
- US-A- 4 739 453

## Description

La présente invention concerne un blindage pour un circuit électronique traitant des signaux radiofréquence.

Les circuits électroniques traitant des signaux radiofréquence comprennent généralement un support tel qu'un circuit imprimé ou un circuit multicouche sur la face avant duquel sont réalisées des pistes d'interconnexion et sont reportés des composants. Ce support incorpore fréquemment un plan de masse situé sur sa face arrière ou, éventuellement, sur une couche interne s'il s'agit d'un circuit multicouche.

Lorsqu'une cellule de ce circuit doit recevoir un blindage électromagnétique, il est connu d'utiliser un boîtier métallique pourvu d'un alvéole dans lequel elle vient se loger. Il est également connu par la demande de brevet FR-A-2 629 664 de disposer sur la face avant du circuit un motif conducteur qui entoure la cellule, motif sur lequel vient s'appliquer un capot métallique.

La continuité du blindage, dans l'épaisseur du support, entre le plan de masse et le capot métallique est généralement assurée par des vis ou des picots métalliques soudés qui relient la face avant et le plan de masse. Ces vis ou ces picots sont des obstacles à une automatisation du montage du circuit et au démontage du capot en cas de dépannage et de réglage.

Ainsi, le brevet US-A-4 739 453 propose d'assurer la continuité du blindage au moyen d'un ensemble de trous métallisés. Cependant, lorsque cette cellule comprend un module de puissance, il est nécessaire d'évacuer l'énergie thermique produite par ce module. Il est connu d'utiliser un radiateur pour ce faire. Le radiateur doit être fixé mécaniquement sur le circuit, ce qui est également un obstacle à l'automatisation du montage de ce circuit.

L'invention a ainsi pour but un blindage pour circuit radiofréquence agissant dans l'épaisseur du support et permettant de refroidir un module de puissance qui ne présente pas les inconvénients précédemment cités.

Le blindage pour circuit radiofréquence, selon l'invention, comprend un support ayant une face active et une face arrière, le support comportant d'une part un plan de masse situé sur sa face arrière ou sur une couche interne du support et d'autre part une cellule du circuit disposée sur la face active du support et coiffée d'un capot métallique, le support comprenant en outre sur sa face active un motif sur lequel s'applique le capot et une ceinture de trous revêtus d'un matériau électriquement conducteur reliant le motif au plan de masse, et se caractérise en ce que le support comprend sur sa face active une surface d'échange sur laqelle est fixé un module de puissance, cette surface d'échange étant recouverte d'un matériau présentant une bonne conductibilité thermique et s'étendant d'une part, sous le module de puissance de la cellule, et d'autre part, sous une ou plusieurs parois du capot situées à proximité immédiate du module de puissance.

Avantageusement, dans le blindage, l'intervalle séparant deux trous consécutifs dans le support est inférieur au tiers de la longueur d'onde des signaux traités par le circuit radiofréquence.

Les différents objets et caractéristiques de la présente invention ressortiront avec de plus amples détails dans la description d'exemples de réalisation donnés à titre non limitatif en se référant aux figures annexées qui représentent :
- la figure 1, une vue en coupe d'un circuit radiofréquence pourvu d'un blindage selon l'état de la technique,
- la figure 2, une vue de dessus de ce circuit,
- la figure 3, une vue en coupe d'un mode de réalisation du blindage selon l'invention,
- la figure 4, une vue de dessus de ce blindage.

Les éléments présents dans différentes figures porterons une seule référence.

On rappellera dans un premier temps l'état de la technique tel qu'il ressort notamment du brevet américain US-A-4 739 453 déjà cité.

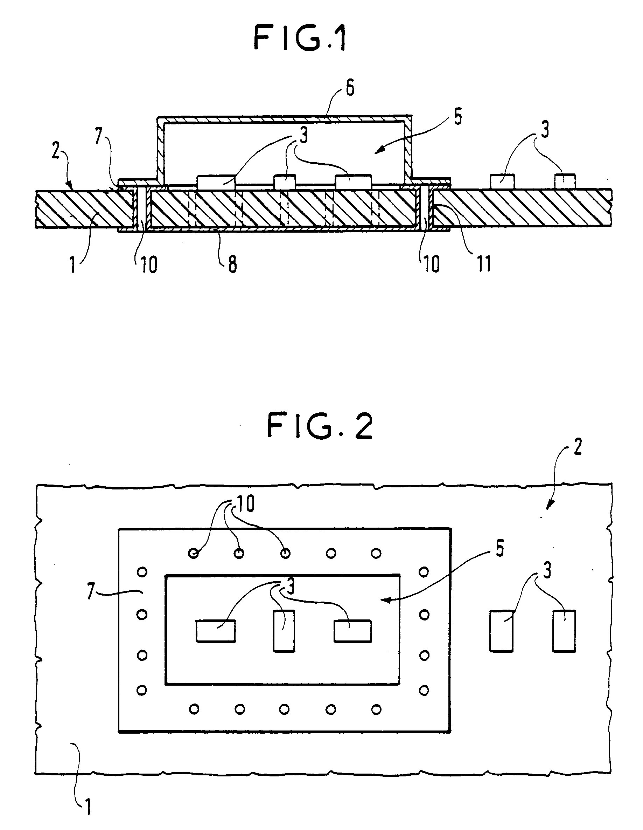

Le circuit radiofréquence représenté en coupe dans la figure 1 comprend un support 1 tel qu'un circuit imprimé, un circuit multicouche ou un substrat céramique. Une face de ce support que l'on conviendra d'appeler face active 2 est munie de composants 3 et de connexions (non figurées) reliant ces composants entre eux. Une cellule 5 de ce circuit, disposée sur la face active, est coiffée d'un capot métallique 6.

Ce même circuit est représenté vu côté face active, capot 6 enlevé, dans la figure 2. Le support 1 comprend un motif 7 électriquement conducteur sur lequel s'applique le capot 6. Il comprend également un plan de masse 8, sous la face active, dont la périphérie coïncide sensiblement avec le contour extérieur du motif 7.

Le plan de masse sera situé, par exemple, sur la face arrière du support ou sur une couche interne d'un circuit multicouche.

Des trous 10 revêtus d'un matériau électriquement conducteur 11, des trous métallisés par exemple, relient le motif 7 au plan de masse 8. Les trous 10 sont prévus tout le long du motif 7. L'association du capot métallique, des trous et du plan de masse constitue un blindage électromagnétique complet de la cellule 5.

L'invention sera maintenant décrite en précisant que le circuit électronique est susceptible d'être monté dans un boîtier métallique. Dans ce cas, le capot 6 pourra être remplacé par un alvéole dans ce boîtier destiné à recevoir la cellule 5. Le terme de capot se réferera donc indifféremment à l'une de ces solutions techniques.

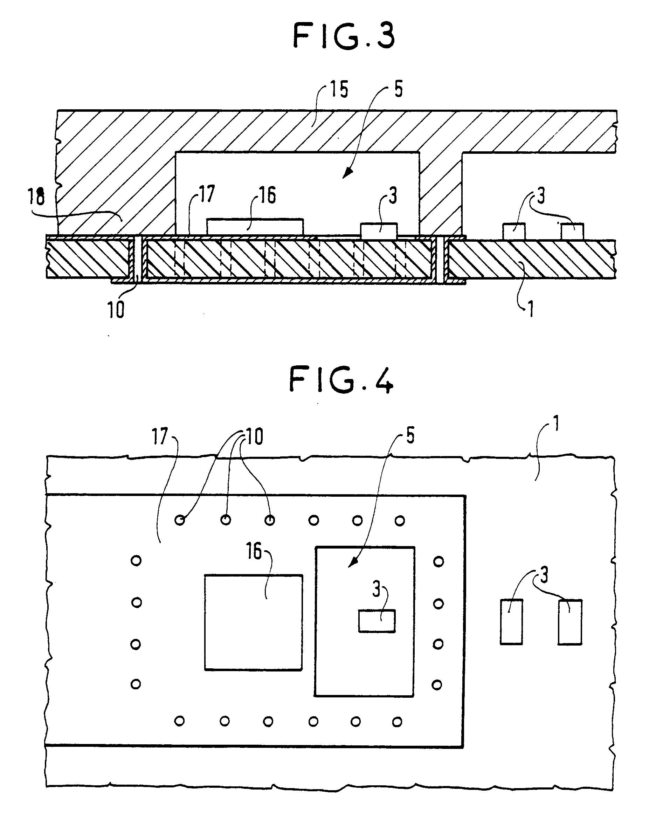

Dans une variante du circuit électronique représentée dans la figure 3, ce dernier est précisément monté dans un boîtier 15. L'ensemble des considérations précédentes s'appliquent mais, de plus, la cellule 5 comprend un module de puissance 16. Ce circuit est représenté vu côté face active, sans le boîtier, dans la figure 4. Une surface d'échange 17 revêtue d'un matériau présentant une bonne conductibilité thermique, située sur la face active 2, s'étend d'une part sous le module de puissance et d'autre part sous une ou plusieurs parois 18 du boîtier 15 situées à proximité immédiate de ce module. Cette surface d'échange sera, par exemple, un plan métallique. L'énergie thermique générée par le module de puissance 16 est donc transférée à la surface d'échange 17, qui elle-même la transfère au boîtier 15.

Le contact entre le motif 7 et/ou la surface d'échange 17 d'une part, et le capot 6 ou le boîtier 15, d'autre part, peut être assuré par pression notamment au moyen d'un matériau qui fait ressort. D'une manière générale, tous les types de fixation connus conviennent, en particulier le soudage, le collage ou le vissage.

Sans sortir du cadre de l'invention, le circuit électronique peut comporter plusieurs cellules blindées, ces cellules étant éventuellement disposées de part et d'autre du support.

Avantageusement, les trous 10 qui forment une ceinture seront espacés d'une distance inférieure au tiers de la longueur d'onde (dans le support considéré) du signal traité par le circuit, de manière à assurer un blindage efficace.

## Revendications

1. Blindage pour circuit radiofréquence, ce blindage comprenant un support (1) ayant une face active et une face arrière, le support comportant d'une part un plan de masse (8) situé sur sa face arrière ou sur une couche interne du support et d'autre part une cellule du circuit disposée sur la face active du support et coiffée d'un capot métallique (15), le support comprenant en outre sur sa face active un motif (7) sur lequel s'applique ledit capot et une ceinture de trous (10) revêtus d'un matériau électriquement conducteur reliant ledit motif (7) audit plan de masse (8), caractérisé en ce que le support comprend sur sa face active une surface d'échange (17) sur laquelle est fixé un module de puissance (16), cette surface d'échange étant recouverte d'un matériau présentant une bonne conductibilité thermique et s'étendant d'une part, sous le module de puissance (16) de la cellule et d'autre part, sous une ou plusieurs parois (18) du capot situées à proximité immédiate du module de puissance.

2. Blindage selon la revendication 1, caractérisé en ce que l'intervalle séparant deux trous (10) consécutif dans ledit support est inférieur au tiers de la longueur d'onde (1) des signaux traités par ledit circuit radiofréquence.

## Patentansprüche

1. Abschirmung für eine Hochfrequenzschaltung mit einem Träger (1), der eine aktive Seite und eine Rückseite aufweist und einerseits eine Massenebene (8) auf seiner Rückseite oder auf einer inneren Schicht des Trägers und andererseits eine Schaltungszelle aufweist, die auf der aktiven Seite des Trägers angeordnet und mit einer Metallkappe (15) abgedeckt ist, wobei der Träger weiter auf seiner aktiven Seite ein Muster (7), auf dem die Kappe aufsitzt, sowie einen Kranz von Löchern (10) aufweist, die mit einem elektrisch leitenden Material ausgekleidet sind, das das Muster (7) mit der Massenebene (8) verbindet, dadurch gekennzeichnet, daß der Träger auf seiner aktiven Seite eine Austauschfläche (17) aufweist, auf der ein Leistungsmodul (16) befestigt ist, wobei die Austauschfläche mit einem Material überzogen ist, das eine gute Wärmeleitfähigkeit besitzt und sich einerseits unter dem Leistungsmodul (16) der Zelle und andererseits unter mindestens einer Wand (18) der Kappe erstreckt, die sich in unmittelbarer Nähe des Leistungsmoduls befindet.

2. Abschirmung nach Anspruch 1, dadurch gekennzeichnet, daß der zwei aufeinanderfolgende Löcher (10) im Träger (1) trennende Abstand kleiner als ein Drittel der Wellenlänge der von der Hochfrequenzschaltung verarbeiteten Signale ist.

## Claims

1. Radio-frequency circuit shield comprising a support (1) having an active side and a rear side, the support comprising an earth plane (8) on its rear side or on an internal layer of the support and a cell of the circuit on the active side of the support and covered by a metal cover (15), the support further comprising on its active side a pattern (7) to which said cover is applied and a belt of holes (10) coated with an electrically conductive material connecting said pattern (7) to said earth plane (8), characterised in that the support comprises on its active side a heat exchange surface (17) to which a power module (16) is fixed and which is covered with a material which is a good conductor of heat and extends under the power module (16) of the cell and under one or more walls (18) of the cover in the immediate proximity of the power module.

2. Shield according to claim 1 characterised in that the distance between two consecutive holes (10) in said support (1) is less than one third the wavelength of the signals processed by said radio-frequency circuit.
